(19) Europäisches Patentamt
European Patent Office
Office européen des brevets

(11) **EP 4 752 569 A1**

(12) **EUROPEAN PATENT APPLICATION**

(43) Date of publication:
03.06.2026 Bulletin 2026/23

(21) Application number: 24216633.8

(22) Date of filing: 29.11.2024

(51) International Patent Classification (IPC):
*G01R 29/08* (2006.01)

(52) Cooperative Patent Classification (CPC):
G01R 29/0885

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: British Telecommunications Public
Limited Company
London E1 8EE (GB)

(72) Inventors:
• SUN, Qiushuo
London E1 8EE (GB)
• SINGH, Alok
London E1 8EE (GB)
• GILKS, Daniel
London E1 8EE (GB)

(74) Representative: **British Telecommunications**
**public limited company**
**Intellectual Property Department**
**9th Floor**
**One Braham**
**Braham Street**
**London E1 8EE (GB)**

(54) **ELECTROMAGNETIC FIELD DETECTOR**

(57) An apparatus (100) for detecting an Electro-Magnetic, EM, field (170), said apparatus comprising a: first Rydberg-Atom EM Field Detector, RAEM-FD (107-1), configured to detect a first EM field (170-1); second RAEM-FD (107-2) configured to detect a second EM field (170-2); and waveguide (105) arranged and configured to guide propagation of the first and second EM fields towards the first and second RAEM-FDs.

Figure 1

## Description

Field of Invention

The present invention relates to an Electro-Magnetic (EM) field detector, and in particular comprising at least two Rydberg-Atom EM Field Detectors (RAEM-FDs) coupled with a waveguide.

Background

In wireless telecommunications, a transmitted wireless signal will decrease in signal strength with distance from a transmission source, for example due to scattering, reflection and propagation losses. Beyond a sensitivity threshold of a wireless receiver, the wireless signal cannot be detected above a background noise level at the receiver. As a result, extrinsic background noise, or the noise floor of the receiving apparatus dominates.

The detection threshold of a wireless receiver places undesirable constraints upon effective wireless telecommunications, and in particular upon range, bandwidth, capacity, and energy-efficiency of the physical layer of radio-based communication.

It is an aim of the present invention to alleviate at least some of the aforementioned problems.

Statements of Invention

According to a first aspect of the present invention, there is provided: an apparatus for detecting an Electro-Magnetic, EM, field, said apparatus comprising a: first Rydberg-Atom EM Field Detector, RAEM-FD, configured to detect a first EM field; second RAEM-FD configured to detect a second EM field; and waveguide arranged and configured to guide propagation of the first and second EM fields towards the first and second RAEM-FDs.

Preferably, the first EM field is different from the second EM field as to, at least: frequency; modulation; and/or transmit power. Preferably, the modulation comprises Amplitude and/or Frequency modulation. Optionally, the frequency is different by a factor of, at least: 2; 4; 10; 100; 1,000; and/or 10,000. Optionally, the first EM field is identical to the second EM field.

Preferably, the waveguide comprises a: Multi-Plate WaveGuide, MPWG; Tapered-Plate WaveGuide, TPWG; Parallel-Plate WaveGuide, PPWG; horn; and/or lens. Optionally, the lens is configured to cause a, convergent or divergent, lensing effect upon at least one of the EM fields. Preferably, the MPWG (and/or lens) comprises: at least three overlapping and non-intersecting plates, and at least two sub-waveguides, each formed by an adjacent pair of the at least three plates, and wherein each sub-waveguide has a separation distance suitable for supporting propagation of the first and second EM fields therethrough. Optionally, the MPWG is configured as a convergent or divergent lens. Optionally, the at least two sub-waveguides are configured such that the separation distances decrease with successive sub-waveguides (i.e. grow closer together), thereby to configure the MPWG as a stepped-index convergent lens. Preferably, the MPWG comprises at least three sub-waveguides. Preferably, the separation distances decrease with each successive adjacent sub-waveguide. Preferably, the separation distances decrease monotonically or continuously with (e.g. each) successive sub-waveguide. Preferably, the at least three sub-waveguides comprise a centremost (or an innermost) one or two of said sub-waveguides. Preferably, the at least three sub-waveguides comprise two outermost sub-waveguides. Optionally the lens is non-optical. Preferably, the at least three sub-waveguides comprise one or two sub-waveguide/s having a greatest separation distance, and more preferably the innermost sub-waveguide/s have said greatest separation distance. Preferably, each of the at least three plates are formed of an electrically conductive material. Preferably, said plates comprise a metal (including a metal alloy), which may in turn consist of or comprise: Aluminium; Copper; Gold; Titanium; Silver; Nickel; Platinum; Tin; and/or Zinc. Preferably, each of the at least three plates is formed as a monolithic plate (or sheet). Preferably, the at least two sub-waveguides share a common plate. Optionally, at least one, or all, of the sub-waveguides consist/s of a vacuum or a dielectric medium arranged therebetween (at least within a corresponding overlapping region), and the dielectric medium may be air or water. Preferably, the first and/or second RAEM-FD/s comprise/s a/an: container (e.g. a vapour cell) comprising a medium of Rydberg atoms; probe laser configured to transmit a probe signal through the vapour cell; coupling laser configured to transmit a coupling signal into the vapour cell and in counter propagation to the probe signal; and a photodetector configured to receive the probe signal having been transmitted through the vapour cell. Optionally, the first and/or second RAEM-FD/s, and more preferably specifically the constituent vapour cell/s, is/are: arranged in the same plane as the waveguide; and/or located outside of, or within, the waveguide. Preferably, at least two, and optionally all, of the at least two sub-waveguides have a width (said width preferably extending parallel to the corresponding adjacent plates and perpendicularly to the propagation of the first and/or second EM field/s within the corresponding sub-waveguide) at least equal to the corresponding wavelength of the first and/or second EM field/s. Preferably, at least two of, and optionally all of, the sub-waveguides have a depth (said depth preferably being perpendicular to the width and perpendicular to the propagation of the first and/or second EM field/s within the corresponding sub-waveguide) at least equal to the corresponding wavelength of the first and/or second EM field/s. Preferably, at least two of, and optionally all of, the sub-waveguides have a separation distance at least equal to, and more preferably at least one-and-a-half times, and still more preferably at least twice, the corresponding wavelength of the first and/or second EM field/s.

As used herein, the term "overlapping" preferably connotes at least a portion of an adjacent pair of the plates coinciding along an axis in which said plates are stacked. Optionally, some, or all, of the plates fully or partially overlap. Optionally, all of plates are mutually overlapping. Preferably, the separation distances are all non-zero. Optionally, all the separation distances are different. Preferably, the separation distances decrease or increase from the centremost to the outermost sub-waveguides. Preferably, the separation distances decrease or increase for each and every adjacent sub-waveguide. Preferably, the separation distances decrease according to a parabolic, hyperbolic, ellipsoid or spherical function. Optionally, the MPWG is symmetric (at least as to separation distances) about the centremost sub-waveguide/s and/or about a single or pair of sub-waveguide/s having the greatest separation distance. Preferably, the waveguide is aligned (and, more preferably, centred), in a direction of propagation of the first and/or second EM field/s through the MPWG, relative to the first and/or second RAEM-FDs. Preferably, the centremost sub-waveguide/s is/are aligned (and, more preferably, centred) with the first and/or second RAEM-FD/s, and still more preferably with the constituent containers. Preferably, each plate is flat. Optionally, the separation distances are equal for at least two of the at least two sub-waveguides. Optionally, all of the sub-waveguides have equal separation distances. Optionally, all, or at least two, of the plates are mutually parallel. Optionally, the MPWG comprises at least four plates, and wherein at least two of said plates are non-parallel. Preferably, the at least two non-parallel plates comprise an adjacent pair of non-parallel plates. Preferably, the adjacent pair of non-parallel plates are arranged such that a largest and a smallest separation distance therebetween is orientated most distally and most proximately the first RAEM-FD, respectively. Preferably, the first and second RAEM-FDs are configured to detect the respective EM fields by exploiting Electromagnetically Induced Transparency. Preferably, the medium of Rydberg atoms comprises or consists of an alkali and/or alkali earth metal, and more preferably Rubidium or Caesium. Optionally, there is provided a single coupling laser and/or a single probe laser, and/or wherein said laser/s is/are shared by both the first and the second RAEM-FDs. Optionally, the output/s of the coupling laser and/or the probe laser are shared by both the first and the second RAEM-FDs, and more preferably wherein said output/s is/are multiplexed thereto (e.g. by means of a multiplexer). Optionally, there is further provided an optical frequency shifter and/or converter (e.g. an Electro-Optic Modulator or an optical parametric oscillator) that is/are arranged and configured to frequency-shift the output of the coupling laser and/or the probe laser to a shifted frequency, and wherein said shifted frequency is directed to (preferably, through the corresponding vapour cell of) only one of the first or second RAEM-FD, and wherein said shifted frequency is tuned to operate said (i.e. first or second) RAEM-FD so as to detect the corresponding (i.e. first or second) EM field. The first and second RAEM-FDs may be excited to the same or different transitions so as to detect the first and second EM fields, respectively. Optionally, the first RAEM-FD and second RAEM-FD comprise different compositions of Rydberg atoms, and more preferably different species of Rydberg atoms. Preferably, the first and second RAEM-FDs are arranged wholly within the waveguide, more preferably wholly within the PPWG or horn, and more preferably within a constituent throat of said horn. Optionally, the PPWG, MPWG and/or TPWG is closed (e.g. providing a complete enclosure for a volume of space) or open (e.g. providing an uninterrupted continuum between a volume of space within the PPWG, MPWG and/or TPWG and free space outside of said PPWG, MPWG and/or TPWG).

Preferably, the second RAEM-FD is arranged downstream of the first RAEM-FD and the waveguide. As used herein, the term "downstream", used relative to the waveguide, preferably connotes regions, and a general direction along a propagation path of an EM field (e.g. the first or second) situated on a side of the waveguide that is distal from an inbound source of said EM field. Preferably, the term "upstream" is to be construed accordingly. Preferably, the first RAEM-FD, second RAEM-FD and the waveguide (e.g. a geometric centre thereof) are arranged in mutual alignment with one another, and more preferably along the propagation path. Preferably, the first and second RAEM-FDs, and more preferably the constituent vapour cells thereof, are adjacent to, and still more preferably are in abutment with, one another. Optionally, relative to the first RAEM-FD, the second RAEM-FD is: offset; stacked vertically; and/or arranged laterally.

Preferably, the first and second EM fields are different at least as to frequency, and the waveguide comprises a convergent lens having a first focus associated with a first frequency of the first EM field and a second focus associated with a second frequency of the second EM field, wherein the first RAEM-FD is arranged at said first focus and the second RAEM-FD is arranged at said second focus. Preferably, the first focus is misaligned with (or not coincident upon) the second RAEM-FD, and preferably the second focus is misaligned with (or not coincident upon) the first RAEM-FD. Optionally, the first and second EM fields are instead identical, at least, as to frequency, such that the first and second foci are the same, and wherein the first RAEM-FD is arranged at both (i.e. spans) the first and second foci, and wherein the second RAEM-FD is arranged elsewhere.

Preferably, the waveguide comprises a divergent lens. Preferably, divergent lens is in the form of a stepped-index lens. Preferably, divergent lens is in the form of a MPWG, in which separation distances of constituent sub-waveguides increase with successive adjacent sub-waveguides, and may increase monotonically.

Preferably, the apparatus further comprises an actuation mechanism, said mechanism in turn comprising at least one of a: first actuator configured to move at least one of the at least three plates so as to change the separation distance of at least one of the at least two sub-waveguides that is associated with said at least one plate; and second actuator configured bodily to move the waveguide, the first and/or the second RAEM-FD/s, so as to change a spacing therebetween along an axis parallel to the propagation of the first and/or second EM field/s through the waveguide. Optionally, the first actuator is configured simultaneously to change the separation distance of at least two, or all, of the at least three plates. Optionally, the first actuator is configured to change the separation distance of at least two, or all, of the at least two sub-waveguides. Optionally, the first actuator is configured to apply the same absolute or relative change in separation distance to each of said at least two or all sub-waveguides. Optionally, the first actuator is configured to apply a different absolute or relative change in separation distance to each of said at least two or all sub-waveguides. Optionally, the second actuator is configured to translate the waveguide and/or the first and/or second RAEM-FD/s only along said axis.

Preferably, the apparatus further comprises a controller configured to tune the first RAEM-FD and/or the second RAEM-FD to detect a third EM field, different to the first and/or second EM field/s. Optionally, the controller is further configured to operate the actuation mechanism so as to reconfigure the apparatus so as to direct the third EM field towards the first and/or second RAEM-FD/s. Optionally, the controller is configured to operate the actuation mechanism so as to focus the third EM field upon the first and/or second RAEM-FD/s. Optionally, the controller is further configured to operate the actuation mechanism so as to reconfigure the apparatus so as to misdirect or block the first, second and/or third EM-field/s from the first and/or second RAEM-FD/s. Optionally, the controller is configured to increase a waveguide cut-off frequency of the waveguide so as to be equal to or greater than the frequency of the first, second and/or third EM-field/s. Optionally, controller is configured to operate the actuation mechanism so as to defocus the first, second and/or third EM-field/s from the first and/or second RAEM-FD/s. Preferably, the controller is configured to receive, from the first and/or second RAEM-FD/s, a reading of signal strength for the first, second and/or third EM-field/s, and wherein the controller is configured responsively to operate the actuation mechanism in dependence upon increasing said received signal strength. Preferably, the controller is configured to tune the first RAEM-FD to detect the first EM field, and/or to tune the second RAEM-FD to detect the second EM field. Preferably, the controller is configured to tune the first and/or second RAEM-FD/s by reconfiguring the probe and/or coupling laser/s to change a frequency of the probe and/or coupling signal/s so as to induce an atomic transition in the constituent vapour cell/s that permits detection of a new (e.g. first, second or third) EM field.

Preferably, the apparatus further comprises a signal processor arranged in communication with the first RAEM-FD and the second RAEM-FD, and configured to receive measurements of the first EM field and second EM field as detected by the respective first RAEM-FD and second RAEM-FD, wherein the signal processor is further configured to process said measurements as single-channel and/or multi-channel communications. Optionally, the signal processor processes said measurements simultaneously or serially.

According to another aspect of the invention, there is provided a radio receiver for a wireless telecommunications network comprising the apparatus as described above. According to another aspect of the invention, there is provided a radiodetermination system comprising an apparatus as described above. Preferably, said radiodetermination system comprises a radar detection, location, and/or navigation system. According to another aspect of the invention, there is provided a medical imaging device or system comprising an apparatus as described above. Preferably, said device or system comprises a Magnetic Resonance Imaging and/or Magnetic Resonance Spectroscopy device or system. According to another aspect of the invention, there is provided a composition analysis instrument comprising an apparatus as described above. Preferably, said instrument is a Nuclear Magnetic Resonance (NMR) spectrometer. According to another aspect of the invention, there is provided a radio-imaging system comprising an imaging array of the apparatus described above.

According to yet another aspect of the invention, there is provided a method of operating an apparatus for detecting an Electro-Magnetic, EM, field, said apparatus comprising a: first Rydberg-Atom EM Field Detector, RAEM-FD; second RAEM-FD; and waveguide arranged and configured to guide propagation of a first and a second EM fields towards the first and second RAEM-FDs, the method comprising the steps of: configuring the first RAEM-FD to detect the first EM field; and configuring the second RAEM-FD to detect the second EM field. Preferably, the first and second EM fields are different at least as to least frequency, and the waveguide comprises a convergent lens having a first focus associated with a first frequency of the first EM field and a second focus associated with a second frequency of the second EM field, and wherein the method further comprises the steps of: arranging the first RAEM-FD at said first focus; and arranging the second RAEM-FD at said second focus.

The above summary is not intended to describe each illustrated embodiment or every implementation of the subject matter hereof. The invention includes any novel aspects described and/or illustrated herein. The invention also extends to methods and/or apparatus substantially as herein described and/or as illustrated with reference to the accompanying drawings. The invention is also provided as a computer program and/or a computer program product for carrying out any of the methods described herein and/or for embodying any of the apparatus features described herein, and a computer-readable medium storing thereon a program for carrying out any of the methods and/or for embodying any of the apparatus features described herein.

Features described as being implemented in hardware may alternatively be implemented in software, and vice versa.

It should be understood that the individual operations used in the methods of the present teachings may be performed in any order and/or simultaneously, as long as the teaching remains operable. Furthermore, it should be understood that the apparatus and methods of the present teachings can include any number, or all, of the described embodiments, as long as the teaching remains operable.

Any apparatus feature may also be provided as a corresponding step of a method, and vice versa. As used herein, means plus function features may alternatively be expressed in terms of their corresponding structure, for example as a suitably-programmed processor.

Any feature in one aspect of the invention may be applied, in any appropriate combination, to other aspects of the invention. Any, some and/or all features in one aspect can be applied to any, some and/or all features in any other aspect, in any appropriate combination. Particular combinations of the various features described and defined in any aspects of the invention can be implemented and/or supplied and/or used independently.

As used throughout, the word 'or' can be interpreted in the exclusive and/or inclusive sense, unless otherwise specified.

The invention extends to an apparatus for detecting an Electro-Magnetic, EM, field, a method of operating the same, and a radio receiver comprising the apparatus, as described herein and/or substantially as illustrated with reference to the accompanying drawings. The present invention is now described, purely by way of example, with reference to the accompanying diagrammatic drawings, in which:

> Figure 1 is a schematic of an EM field detector comprising a waveguide;
> Figures 2a, 2b and 2c show, in detail, a first example of the waveguide; and
> Figure 3 shows a second example of the waveguide.

While various embodiments are amenable to various modifications and alternative forms, specifics thereof have been shown by way of example in the drawings and will be described in detail. It should be understood, however, that the intention is not to limit the claimed inventions to the particular embodiments described. On the contrary, the intention is to cover all modifications, equivalents, and alternatives falling within the spirit and scope of the subject matter as defined by, at least, the claims.

Specific Description

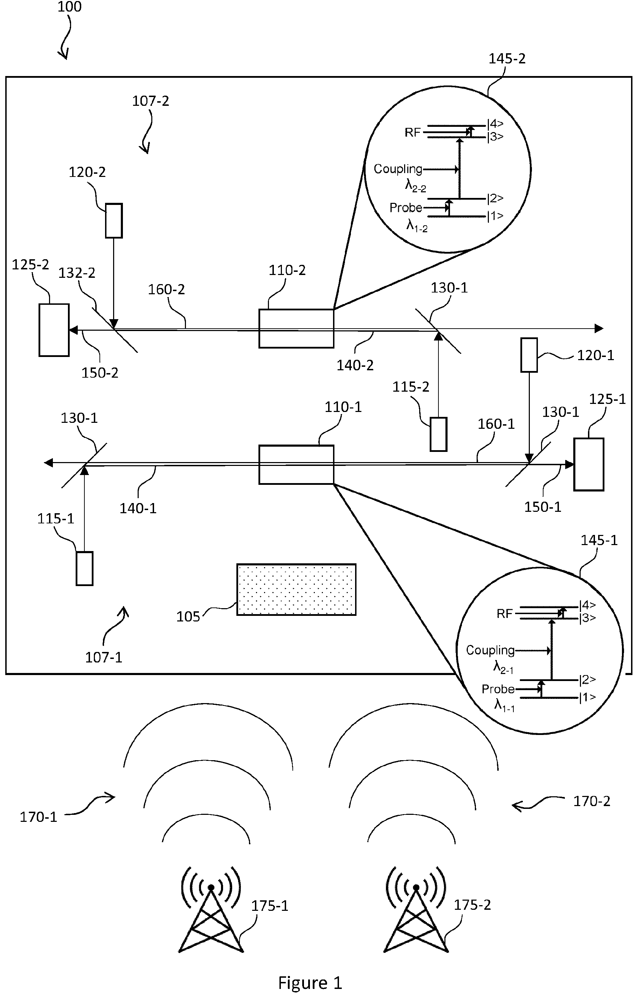

Figure 1 schematically shows an apparatus in the form of an Electro-Magnetic (EM) field detector 100 comprising a: waveguide 105; first Rydberg-Atom EM Field Detector (herein "RAEM-FD") 107-1; and second RAEM-FD 107-2.

The first RAEM-FD 107-1 (also known as an "atomic receiver" or a "quantum-optical receiver") in turn comprises a: first Rydberg vapour cell 110-1; first probe laser 115-1; first coupling laser 120-1; first photodetector 125-1; and a first pair of beamsplitters (e.g. dichroic mirrors) 130-1. Correspondingly, the second RAEM-FD 107-2 comprises a: second Rydberg vapour cell 110-2; second probe laser 115-2; second coupling laser 120-2; second photodetector 125-2; and a second pair of beamsplitters (e.g. dichroic mirrors) 130-2.

Each Rydberg vapour cell 110 comprises a container (e.g. a sealed glass, ceramic or Perspex vessel) containing a low-density vaporous medium of Rydberg atoms, such as alkali metal (e.g. Rubidium-85 or Caesium-133) or alkaline earth metal atoms (e.g. Strontium-88). The first 110-1 and second 110-2 Rydberg vapour cells are available to be identical or different at least as to the species of Rydberg atoms within the vaporous medium.

A Rydberg atom is an atom with at least one electron excited to a very high principal quantum number ($n \gg 1$). Rydberg atoms experience very large dipole moments and long decay periods; these characteristics are exploited by each RAEM-FD 107 so as to receive, detect and demodulate EM fields over very large frequency ranges (compared to conventional conductive antennas), typically between so-called (as defined by the International Telecommunication Union) medium and super-high frequencies (e.g. between 1MHz and 30GHz), but as low as extremely low frequencies, and as high as infrared frequencies (e.g. between 3Hz and 1THz), in some examples. For conciseness, as used herein, the terms "radio" and "radio frequency" include, in addition to conventional radio frequencies, far infrared frequencies that are known to be detectable by a suitably configured RAEM-FD.

Each Rydberg atom has a ground state and a plurality of excited states, which may be excited (*i.e.* by absorbing a photon of sufficient energy that permits electron transition) from the ground state to an excited state. The electron then transitions by decay from the excited state to a lower excited state (i.e. an excited state at a lower energy level) or to the ground state, with certain transitions being unpermitted because they are dipole forbidden.

The first 107-1 and second 107-2 RAEM-FDs are now described in more detail below, albeit with general reference (unless otherwise specified) to aforementioned common components of each RAEM-FD. As such, unless otherwise specifically stated, the description that follows is intended to apply equally and independently to the first RAEM-FD 107-1 and to the second RAEM-FD 107-2, as appropriate, and has therefore been generalised for succinctness. Correspondingly, in the figures, features associated with the first RAEM-FD 107-1 are provided with reference numerals suffixed with "-1" (i.e. "110-1"), whereas features associated with the second RAEM-FD 107-2 are provided with reference numerals suffixed with "-2" (i.e. "110-2").

For a given one of the first 107-1 and second 107-2 RAEM-FDs, the probe laser 115 is configured and arranged to transmit - via the corresponding one of the pair of beamsplitters 130 - a probe signal 140 through the corresponding Rydberg vapour cell 110, and thus the constituent Rydberg atoms (e.g. Rb-85 for the first vapour cell 110-1, and Cs-133 for the second vapour cell 110-2), in which the probe signal 140 is at a first wavelength, $\lambda_1$ (e.g. for the first probe signal 140-1, said first wavelength is $\lambda_{1-1} \approx 780nm$, and for the second probe signal 140-2, said first wavelength is $\lambda_{1-2} \approx 852nm$) corresponding to an energy required to elevate an outer electron of the Rydberg atoms from a ground state (|1>) to a first excited state (|2>); these transitions are shown, for each of the first and second RAEM-FDs 107, in the corresponding electron transition diagrams 145 in Figure 1. The probe signal that emerges from the Rydberg vapour cell 110 is referred to as the output signal 150 and is used to detect an incident EM field 170 (e.g. a radio-frequency signal) from an EM source 175 (e.g. a cellular base station, but including any radiating or reflecting body), as described below in more detail, such that the first RAEM-FD 107-1 is configured to detect a first EM field 170-1 from a first EM source 175-1, and that the second RAEM-FD 107-2 is configured to detect a second EM field 170-2 from a second EM source 175-2.

Simultaneously, the coupling laser 120 is configured and arranged to transmit - via the corresponding other of the associated pair of beamsplitters 130 - a coupling signal 160 through the corresponding Rydberg vapour cell 110 in counter-propagation (to help reduce Doppler shifting) to, and overlapping with, the corresponding probe signal 140, in which the coupling signal 160 is at a second wavelength $\lambda_2$ (e.g. for the first coupling signal 160-1, said second wavelength is $\lambda_{2-1} \approx 480nm$, and for the second coupling signal 160-2, said second wavelength is $\lambda_{2-2} \approx 510nm$), corresponding to an energy required to elevate the outer electron of the Rydberg atoms from the first excited state (|2>) to a Rydberg state (|3>), and having greater power than the probe signal. The transition from the first excited state (|2>) to the Rydberg state (|3>) is also shown in each corresponding electron transition diagram 145 in Figure 1. Accordingly, a three-level atomic system is created (it will be appreciated by the person skilled in the art that a four-level system could correspondingly be used, for example by introducing a repump laser, with potential increases in detection sensitivity). To help (further) reduce Doppler shifting, the probe 115 and coupling 120 lasers are frequency stabilised.

In a quantum-optical and quantum-interference process known as Electromagnetically Induced Transparency (EIT), two excitation paths (e.g. |1> → |2> and |2>→|3>) interfere destructively and create a transparency window for the probe signal 140 operating at $\lambda_1$. For example, in an EIT ladder scheme, transition from the Rydberg state (|3>) to the ground state (|1>) is forbidden, and the ground state (|1>) becomes depopulated and so fewer atoms can absorb the probe signal 140. Accordingly, the Rydberg atoms become more transparent to the probe signal 140. EIT is also realisable using other electron transition schema, such as vee and lambda.

Regardless, the corresponding photodetector 125 is arranged downstream of the Rydberg vapour cell 110 and in the path of the corresponding output signal 150, and is configured to measure, at least, (spectrographic) amplitude of said output signal 150. Depending on the EIT state of the Rydberg atoms, further physical effects can be exploited to detect the corresponding EM field 170 from real-time optical measurements of the output signal 150 by the photodetector 125.

Since the outer electron of the Rydberg atom is much further away from the atomic nucleus when in the Rydberg state (|3>) compared to the ground state (|1>), a high polarizability and a large dipole moment (i.e. through strong Rabi oscillation) is created. The outer election becomes responsive to the EM field 170 so as to cause a further transition of said electron from the Rydberg state (|3>) to an adjacent Rydberg state (|4>) when the photon energy of the EM field 170 matches the required transition energy (e.g. for the first RAEM-FD 107-1, having a frequency of ~3.43GHz, and ~28.679GHz for the second RAEM-FD 107-2), which causes splitting of said states into "dressed states" in a process known as Autler-Townes splitting. In turn, this state splitting causes, by EIT, the Rydberg atoms to become less transparent to the probe laser 140, causing a decrease in amplitude of the output signal 150 to an extent that is proportional to the amplitude of the incident EM field 170. The RAEM-FD 107 is operable to detect the corresponding EM field, and in particular Amplitude Modulated (AM) signals, by measuring changes in amplitude of the output signal 150. The publication C. Holloway et al., "A Multiple-Band Rydberg Atom-Based Receiver: AM/FM Stereo Reception" in IEEE Antennas and Propagation Magazine, vol. 63, no. 3, pp. 63-76, June 2021, doi: 10.1109/MAP.2020.2976914, which is herein incorporated by reference, provides details of E-field metrology using Rydberg atom-based techniques (and in particular splitting of the optical transparency region due to the presence of the incident EM field and correlation with EM field amplitude).

Correspondingly, in another example, the RAEM-FD 107 is configured to detect Frequency Modulated (FM) signals. That is, when frequency of the EM field 170 changes (or "detunes") from the frequency required for the transition between the Rydberg state (|3>) and the adjacent Rydberg state (|4>), EIT resonance again causes Autler-Townes splitting. The separation of the two peaks increases with EM field detuning. By locking the probe laser 115 and coupling laser 120 to particular frequencies, then the output signal 150 is directly correlated to the frequency modulation of the EM field, and spectrographic analysis thereof permits detection of the FM modulation. The publication D. A. Anderson et al., "An Atomic Receiver for AM and FM Radio Communication, " in IEEE Transactions on Antennas and Propagation, vol. 69, no. 5, pp. 2455-2462, May 2021, doi: 10.1109/TAP.2020.2987112, which is herein incorporated by reference, provides a methodology for FM signal detection.

In yet a further example, the RAEM-FD 107 is configured to detect phase modulated EM fields, such as those of Binary Phase-Shift Keying (BPSK), Quadrature Phase-Shift Keying (QPSK), and Quadrature Amplitude Modulation (QAM) signals (used in many wireless and cellular communications protocols). In these modulation schemes, a signal is transmitted by modulating the phase of a carrier signal in the EM field 170. To detect the carrier's phase, a reference EM signal that is on-resonance with the transition to the Rydberg state (|3>) is applied to the Rydberg atoms, which acts as a local oscillator. A difference in frequencies between the carrier and reference EM signals, or the "intermediate frequency", is detected and the phase of the intermediate frequency signal corresponds directly to the relative phase between the local oscillator and the EM field 170.

In any event, the RAEM-FD 107 is configured to detect the specific frequency of the corresponding EM field 170 by selecting a particular value of $\lambda_2$ so that electrons of the Rydberg atoms are elevated to a particular Rydberg state (|3>). This particular Rydberg state (|3>) is selected so that photons at the specific frequency of the EM field 170 elevate electrons from this Rydberg state to its adjacent Rydberg state (|4>), which induces a change in the EIT that is then detected by the corresponding photodetector 125 from characteristics of the output signal 150.

Accordingly, there are provided, by means of the first and second RAEM-FDs 107, and the associated first 125-1 and second 125-2 photodetectors, two EM field detectors capable of detecting the first 170-1 and second 170-2 EM fields, respectively.

Regardless of the modulation scheme used (amplitude, frequency and/or phase), where the first 170-1 and second 170-2 EM fields are substantially different (e.g. as to frequency and/or modulation mode), the first 107-1 and second 107-2 RAEM-FDs form dedicated detectors for said EM fields, thereby permitting the EM field detector 100 to receive multi-channel communications via, at least, the first 170-1 and second 170-2 EM fields. Where the first 170-1 and second 170-2 EM fields are substantially identical (e.g. as to frequency and/or modulation mode), the first 107-1 and second 107-2 RAEM-FDs form redundant detectors for said EM fields, which may be used to improve signal-to-noise ratio, resilience, cross-validation, signal fusion / augmentation, and/or bandwidth.

Furthermore, to help passively improve sensitivity, the first 107-1 and second 107-2 RAEM-FDs are coupled to the common waveguide 105 to form the EM field detector 100.

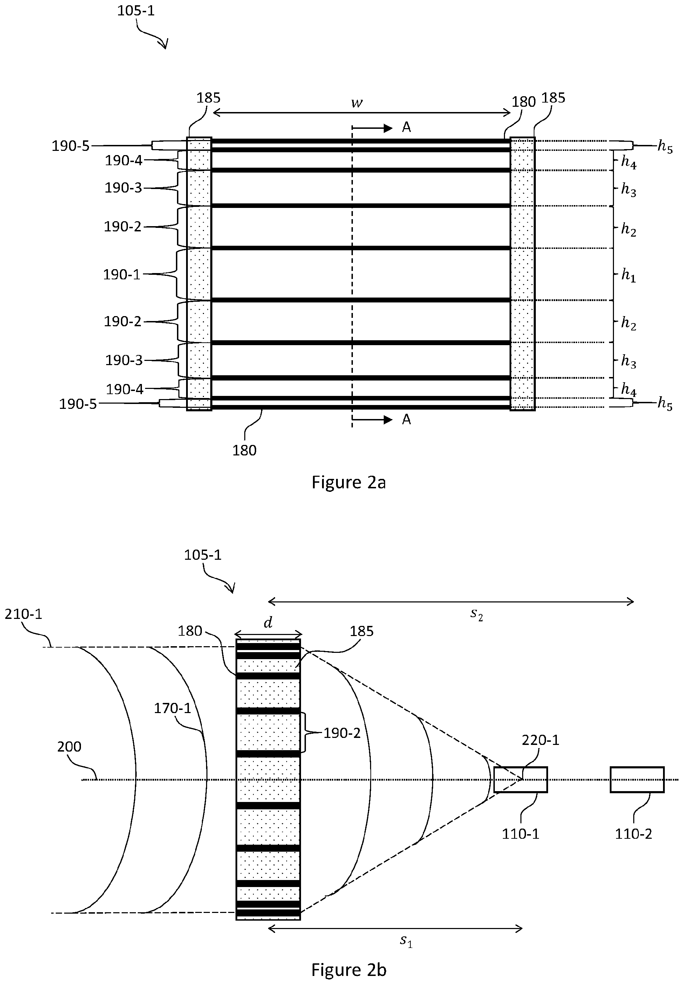

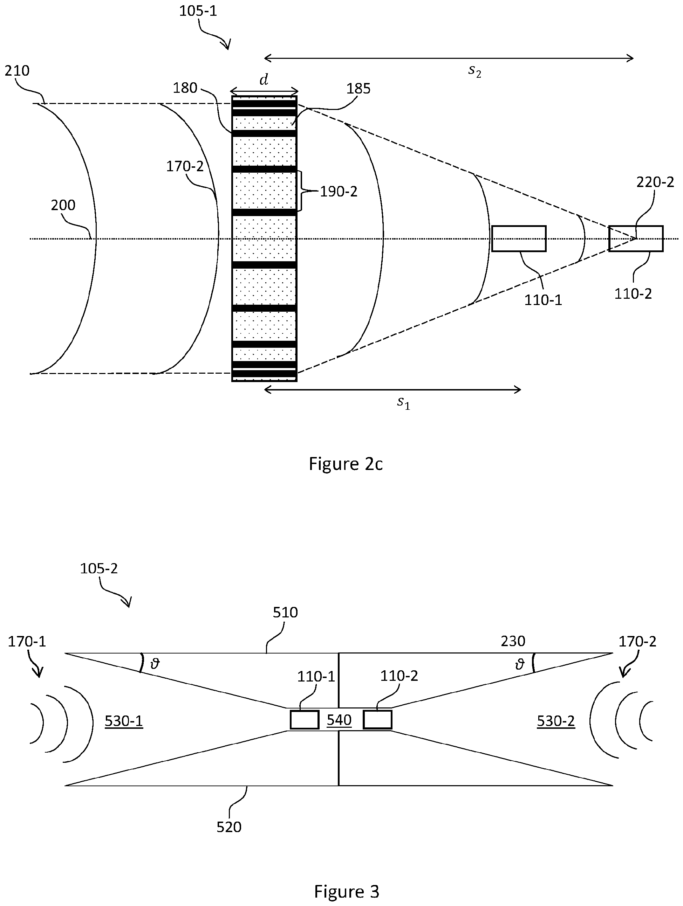

Figures 2a, 2b and 2c show a first example 105-1 of the waveguide, in which said waveguide is in the form of a Multi-Plate WaveGuide (MPWG) that is configured as a stepped-index convergent lens suitable for focussing the first 170-1 and second 170-2 EM fields onto the RAEM-FDs 107, and specifically the constituent vapour cells 110 (with features of the wider EM field detector 100 omitted for conciseness).

Figure 2a shows the lens 105-1 in a front elevation and a cross-section along line A-A. Figure 2b further schematically shows propagation of the first EM field 170-1 through the lens 105-1 and to the first Rydberg vapour cell 110-1, whereas Figure 2c schematically shows propagation of the second EM field 170-2, having - in this example - a different frequency to that of the first EM field 170-1, through the lens 105-1 and to the second Rydberg vapour cell 110-2.

The lens 105-1 comprises a plurality of (exemplarily in Figures 2, ten) stacked, and fully overlapping, plates 180 that are each mutually parallel and that are fixed at opposing terminal ends to a pair of endplates 185, thereby forming a ladder-like structure. Each plate 180 is formed of an electric conductor, and in particular a metal (e.g. comprising or consisting of Aluminium, Copper, Nickel, Silver and/or Titanium).

Each adjacent pair of plates 180, along with the endplates 185, define an open-ended and air-filled rectangular sub-waveguide 190, and the lens 105-1 comprises a plurality of (exemplarily in Figures 2, nine) sub-waveguides, including a/an: single innermost sub-waveguide 190-1, formed by a pair of the innermost (or centremost) plates; pair of second sub-waveguides 190-2, stacked adjacent both sides of the innermost sub-waveguide 190-1, wherein each of the second sub-waveguides 190-2 share a constituent plate of the first sub-waveguide 190-1; and successive third 190-3, fourth 190-4 and outermost 190-5 pairs of sub-waveguides that further nest outwardly from the innermost 190-1 and second 190-2 sub-waveguides in a corresponding manner.

The pair of plates 180 forming a given sub-waveguide 190 are separated by an inter-pair separation height, $h_i$, where $i$ denotes an index of a given waveguide, such that $i$ = 1, 2, 3, 4 and 5 for the innermost waveguide 190-1, and the pair of second 190-2, third 190-3, fourth 190-4, and outermost 190-5 waveguides, respectively.

The value of $h_i$ dictates the local phase refractive index, $n_i$, of the corresponding $i^{th}$ waveguide/s, according to *Equation 1* below:

$$n_i = \sqrt{1 - \left(\frac{c}{2h_i f}\right)^2}$$

in which, c is the speed of light in a vacuum, and $f$ is a frequency of the incident EM field, and specifically the frequency of the first EM field 170-1, $f_1$, and of the second EM field 170-2, $f_2$. The refractive index of the media contained within the sub-waveguides 190 has been taken to be 1 (as is substantially appropriate in the present case of the air-filled sub-waveguides in a like atmospheric environment), and is therefore not shown as a term.

To configure the lens 105-1 as a convergent lens, successive adjacent sub-waveguides 190, from the innermost sub-waveguide 190-1 to the outermost sub-waveguides 190-5, are arranged such that the respective value of $h_i$ monotonically decreases, and the values of $n_i$ therefore correspondingly decrease as governed by *Equation 1;* that is, $h_1 > h_2 > h_3 > h_4 > h_5$, and $n_1 > n_2 > n_3 > n_4 > n_5$.

Values of $h_i$ are selected to achieve a desired refractive index for $f_1$ and $f_2$, and in turn a desired overall convergent lensing effect achieving a focal length, $s_1$ for $f_1$, and $s_2$ for $f_2$. In this example, $s_2 > s_1$, since $f_1 > f_2$. For example, values of $h_i$ are selected to form a stepped-index lens having a profile approximating a parabola or mimicking a section of a hyperbola, ellipse, or circle.

Each sub-waveguide 190 has a width, $w$, which is the lateral extent of each constituent pair of plates 180 between each endplate 185. In the example of Figures 2, $w$ is equal for all sub-waveguides 190. Ideally, $w$ is substantially equal to, or greater than, the wavelength of the first and second EM fields 170, with larger values of w increasing the aperture of the lens 105-1, thereby increasing an energy collection area. Furthermore, the lens 105-1 is dimensioned such that the values of $h_i$ and w provide sub-waveguides 190 having a waveguide cutoff frequency no less than $f_1$ and $f_2$.

Perpendicularly to w and in the plane of each plate 180, each plate has a depth, $d$, which is - in this example - equal for all plates (and thus also for all sub-waveguides 190). The value of d is approximately at least equal to the corresponding wavelength for $f_1$ and/or $f_2$, thereby to create a guided mode (as opposed to inducing diffractive effects) for, at least, the constituent E-field of the EM fields 170. To help reduce scattering, each plate 180 is dimensioned to have negligible thickness relative to $f_1$ and $f_2$ (*e.g.* less than 2mm or so).

Figure 2b illustrates propagation of the first EM field 170-1 through the lens 105-1, represented schematically by first ray lines 210-1 (shown with long-dash lines). The first EM field propagating through the lens 105-1 is effectively directed towards the region having the greatest refractive index, *i.e.* $n_1$, and specifically towards a propagation plane 200 (shown in profile with dotted lines, and bisecting - parallel to the constituent plates 180 of - the innermost sub-waveguide 190-1) and on to $s_1$ 220-1. In contrast, Figure 2c illustrates propagation of the second EM field 170-2 through the lens 105-1, represented schematically by second ray lines 210-2 (shown with long-dash lines). The second EM field propagating through the lens 105-1 is effectively directed to $s_2$ 220-2.

As shown in Figures 2b and 2c, the lens 105-1 is separated, along the propagation plane 200, from the first Rydberg vapour cell 110-1 by $s_1$, such that, for the first EM field 170-1, a first focal line (*i.e.* extending, at $s_1$, parallel to w) of the lens 105-1 lies within, and ideally at a geometric centre of, the first Rydberg vapour cell 110-1. Furthermore, the lens 105-1 is separated, along the propagation plane, from the second Rydberg vapour cell 110-2 by $s_2$, such that, for the second EM field 170-2, a second focal line (*i.e.* extending, at $s_2$, parallel to $w$) of the lens 105-1 lies within, and ideally at a geometric centre of, the second Rydberg vapour cell 110-2. Given the relative values of $s_1$ and $s_2$, the second Rydberg vapour cell 110-2 is arranged downstream of the first Rydberg vapour cell 110-1 and the lens 105-1; said components are also arranged in mutual alignment along the propagation plane 200.

Accordingly, the EM field detector 100 of Figure 2 provides dual detectors, in the form of the RAEM-FDs 107, that are arranged at different foci (*i.e.* $s_1$ and $s_2$) of the lens 105-1 for the respective different frequencies (*i.e.* $f_1$ and $f_2$) that each RAEM-FD is tuned to detect. Thus, owing to chromatic aberration, the power-concentrating effect of the lens 105-1 upon the EM fields 170 may be extended across the different, and dedicated, pair of RAEM-FDs 107; this is particularly advantageous when the first and second EM fields 170 are simultaneously received at the EM field detector 100, allowing improved multi-channel communication using only a single lens, and reducing a need for refocussing.

Exemplary dimensions of the innermost sub-waveguide 190-1 are: $h_1$= 29mm (and successively decreasing by 2mm with each successive waveguide, *i.e.* such that $h_5$ = 21 mm); w = 800mm; and d = 36mm. At such dimensions, and where $f_1$ = 10.1 GHz (which corresponds with the transition $^{61}D_{5/2}$ to $^{60}F_{7/2}$ of Rb-85 for the first RAEM-FD 107-1), the lens 105-1 focuses the first EM field 170-1 to $s_1 \approx$ 178mm. Where the first EM field 170-1 has a beam diameter of $\approx$ 300mm, a depth of field of $\approx$ 90mm results. Correspondingly, where $f_2 \approx$ 10.7GHz (which corresponds with the transition $^{60}D_{5/2}$ to $^{59}F_{7/2}$ of Rb-85 for the second RAEM-FD 107-2), the lens 105-1 focuses the second EM field 170-2 to $s_2 \approx$ 203mm. Where the second EM field 170-2 has a beam diameter of $\approx$ 300mm, a depth of field of approximately $\approx$ 100mm results. Various other parameters of the EM fields 170 (*e.g.* collimation, and angle of incidence) may affect $s_1$ and $s_2$, as well as associated focal parameters (*e.g.* focal depth and diameter).

To improve efficacy, the lens 105-1 is also orientated towards and aligned with the EM sources 175, such that the EM fields 170 are caused to propagate within the sub-waveguides 190 and are focussed onto the respective one of the RAEM-FDs 107.

Figure 3 shows, in profile, a second example 105-2 of the waveguide, in which said waveguide is in the form of a Tapered Plate WaveGuide (TPWG), and specifically in the form of a double-sided horn.

The TPWG comprises a first plate 510 and a second plate 520, formed of an electrical conductor (*e.g.* a metal), arranged to provide, therebetween, a volume forming a pair of flared mouths 530 and a shared straight throat 540.

The pair of flared mouths 530 comprises a first mouth 530-1 and a second mouth 530-2, wherein said mouths are arranged at terminal and distal ends of the TPWG, and are interconnected via the throat 540. The first 510 and second 520 plates are separated such that the throat 540 provides a waveguide cutoff frequency below the frequency of the first 170-1 and second 170-2 EM fields to which the first 107-1 and second 107-2 RAEM-FDs are tuned.

The first 110-1 and second 110-2 vapour cells are arranged within the throat 540, such that the first vapour cell is most proximate to the first mouth, and the second vapour cell is most proximate to the second mouth. Features of the wider EM field detector 100 have been omitted from Figure 3 for conciseness.

The TPWG 105-2 increases, in two directions, an effective aperture size of the EM field detector 100, thereby to increase inbound power collection over multiple directions. In use, when the mouths 530 are orientated toward the inbound EM fields 170, the respective EM field is concentrated by the corresponding mouth into the throat 540 and toward the vapour cells 110.

The first 110-1 and second 110-2 vapour cells are arranged within the throat such that the corresponding incoming EM fields 170 are not attenuated by the other vapour cell or associated parts.

As will be appreciated, the aperture extent of each mouth 530, taper angle of each mouth ($\theta$), separation distance between the first 510 and second 520 plates, and smoothness of the transition between each mouth and the throat, may all affect gain and propagation mode, and are therefore to be selected to ensure effective propagation of the EM fields 170 through the TPWG and on to the corresponding vapour cell 110. Accordingly, the shape and dimensions of the first 530-1 and second 530-2 mouth can be designed to adjust sensing gain for the first and second EM fields according to the corresponding tuning of the respective associated vapour cell 110. As such, the first and second mouths are available to be symmetrical or asymmetrical, such that any power-concentrating effects are tailored to the EM field to be detected and the tuning of the corresponding vapour cell.

To remain effective as a waveguide or lens at low frequencies, the various waveguides 105 described above become impractically large. However, when the RAEM-FD 107 is configured and operated to be ultra-wideband (*e.g.* with appropriate control of lasers 115, 120, and/or a local oscillator, if provided), the waveguide may remain small and permit increased sensitivity at high frequencies detectable by the RAEM-FD, whilst simultaneously causing negligible detriment to detection of low frequencies by the same RAEM-FD.

Advantageously, the waveguide (whether in the form of the lens 105-1 or TPWG 105-2) also has the effect of helping selectively to filter-out interference at or below the cutoff frequency of said waveguide.

Alternatives and Modifications

In an alternative, the MPWG is configured as a non-lensing waveguide, in which the lens 105-1 is modified such that each of the sub-waveguide 190 all (substantially) have the same value of $h_i$, for example as described as described in co-pending European Patent Application Number 24197354.4 (filed 29 August 2024) in the name of *British Telecommunications public limited company,* and specifically as described, at least, on p. 14, the contents of which are herein incorporated by reference. In such case, the non-lensing waveguide additionally comprises a tuning system configured to vary the value of $h_i$ (*e.g.* to maintain the waveguide cutoff frequency below the frequencies of the EM fields 170 that are sought to be detected).

It will be appreciated that the waveguide 105 is available to have any number of the sub-waveguides 190. For example, where there is provided only one sub-waveguide, a so-called Parallel-Plate WaveGuide (PPWG) results. In another example, the MPWG comprises at least two sub-waveguides.

In another example, the MPWG is available to comprise only an odd or even number of sub-waveguides 190 (and in the latter case, as applied to the lens 105-1, there are consequently two innermost sub-waveguides 190-1). For the same values of $h_i$, more sub-waveguides 190 provide a larger aperture. In the case of the lens 105-1, more sub-waveguides permit a smoother index-stepped lens to be formed.

Although the lens 105-1 is shown in Figures 2 as being symmetric about plane 200, it will be appreciated that asymmetric forms are also adoptable, such that there are a different number of sub-waveguides 190 and/or different values of $h_i$ to one side of the innermost sub-waveguide 190-1 than to the other side. For example, the inter-pair height is available to decrease monotonically from one end to the other.

In a more specific alternative, the lens 105-1 is instead configured as a divergent lens by instead monotonically increasing $h_i$ from the innermost sub-waveguide 190-1 to the outermost sub-waveguides 190-5 (and $n_i$ correspondingly). Such a divergent lens may help filter, or dissipate, interference reaching one of, or both, the RAEM-FDs 107. The divergent lens is available to be provided additionally (*e.g.* in series, before and/or after), or alternatively to, the lens 105-1 and/or TPWG 105-2.

In yet another example of the lens 105-1, the

value of $h_i$ is available to vary in any manner (alternative to the aforementioned monotonic variation) to provide an intended lensing effect, including as a complex lens having non-monotonic variation of $h_i$.

Additionally or alternatively, the lens 105-1 is formed as a tuneable stepped-index convergent waveguide lens (or a *"tuneable lens"* or *"trans-tuneable lens"*), for example as described in co-pending European Patent Application Number 24179958.4 (filed 4 June 2024) in the name of *British Telecommunications public limited company,* and specifically as described, at least, on pp. 13-17, the contents of which are herein incorporated by reference. In this way, the focal lines 220-1 and 220-2 are adjustable so as to coincide with a selected (appropriately tuned) one or more of the vapour cells 110 *(e.g.* in response to changes in frequency of at least one of the EM fields 170).

Additionally or alternatively, the lens 105-1 is formed as a translatable stepped-index convergent waveguide lens (or a *"translatable lens"),* for example, as also described in co-pending European Patent Application Number 24179958.4 (filed 4 June 2024) in the name of British Telecommunications public limited company, and specifically as described, at least, on pp. 15-16, the contents of which are herein incorporated by reference. In this way, the focal lines 220 of the translatable lens are adjustable so as to coincide with a selected (appropriately tuned) one or more of the vapour cells 110 *(e.g.* in response to changes in frequency in at least one of the EM fields 170). For example, there is provided an extendable linear actuator that permits an increase and decrease in separation between the lens 105-1 and the vapour cells 110.

In an alternative to the TPWG 105-2, where the dimensions of the TPWG relative to the vapour cells 110 do not permit locating at least one of the latter within the throat 540 (*e.g.* for high frequencies), at least one of the vapour cells 110 is arranged outside the throat - in alignment therewith and downstream therefrom, which may be accommodated by providing an enlarged cavity within the throat or a break in the throat.

In an alternative, the TPWG 105-2 is in the form of a horn of a pyramidal, spiral, conical, exponential, dual-mode conical, diagonal, ridged, septum, aperture-limited, corrugated, or open boundary quad-ridged kind.

In an alternative, the TPWG 105-2 is configured as a PPWG, such that first 510 and second 520 plates have a constant separation therebetween along their entire lengths, effectively rendering said plates parallel.

In an alternative, the MPWG, including the lens 105-1, comprises inclined (and therefore non-parallel) plates. In particular, said inclined plates are inclined such that inter-pair height decreases towards the RAEM-FDs 107, and increases away therefrom. In this way, there may be provided a lens-horn.

In an alternative, the waveguide 105 is in the form of a re-orientable waveguide configured to be re-orientated so as to re-align the re-orientable waveguide between the RAEM-FDs and at least one of the EM sources 175. For example, the re-orientable waveguide is described in co-pending European Patent Application Number 24197354.4 (filed 29 August 2024) in the name of *British Telecommunications public limited company,* the contents of which are herein incorporated by reference.

It will be appreciated that the EM field detector 100 is available to incorporate alternative forms of the RAEM-FDs 107 that are apparent to the person skilled in the art, especially having alternative quantum (e.g. as to the selected Rydberg atom and electron transitions, and the operation of the lasers 115, 120) and optical (e.g. absent the beamsplitters, such that the probe laser 115 is directly aligned with the corresponding vapour cell 110) configurations.

In a further specific such alternative, to help reduce cost and complexity, there is provided a single probe laser 115 and/or a single coupling laser 120 that is/are shared by both, or all, of the RAEM-FDs. To help operate the different RAEM-FDs 107 in different ways (and therefore detect different kinds of EM fields 170), an optical frequency shifter and/or converter (e.g. an Electro-Optic Modulator or an optical parametric oscillator) is/are arranged and configured to frequency-shift the output of said coupling laser and/or probe laser to a shifted frequency, such that said shifted frequency is directed to one of the first or second RAEM-FD so as appropriately to operate said RAEM-FD.

It will be appreciated that the EM field detector 100 is available to comprise at least two, and therefore three or more, of the RAEM-FDs 170, with appropriate coupling to the waveguide 105, so as, at least, to increase bandwidth, redundancy, resilience, and/or simultaneously to focus more EM fields of different frequencies upon multiple RAEM-FDs.

Furthermore, it will be appreciated that the at least two RAEM-FDs are available to be arranged in any relative positions, including: arranged serially (*i.e.* along the propagation path); and/or stacked vertically or arranged laterally (*i.e.* perpendicularly to the propagation path). As such, an array of the RAEM-FDs is available to be provided. Further still, the waveguide 105 is also available to be arranged in any such corresponding relative positions (*i.e.* arranged serially, stacked vertically and/or arranged laterally), thereby effectively providing an array of the EM field detectors 100 described above.

In an alternative, at least one of the RAEM-FDs 107 is encased within the waveguide 105, which provides a closed metal enclosure therefor. This permits an E-field of the EM fields 170 to oscillate inside the enclosure, thereby further enhancing signal intensity at said vapour cell/s 110.

In an alternative, the first 175-1 and second 175-2 EM sources. In an alternative, the first 170-1 and second 170-2 EM fields are available to be combined, for example to provide a multifrequency signal (and in particular a wideband signal). In yet another alternative, the second 170-2 EM field is a multipath component (e.g. affected by reflection, refraction, and/or diffraction) of the first EM field.

In one embodiment, the system and/or its components or subsystems can include computing devices, microprocessors, modules and other computer or computing devices, which can be any programmable device that accepts digital data as input, is configured to process the input according to instructions or algorithms, and provides results as outputs. In one embodiment, computing and other such devices discussed herein can be, comprise, contain or be coupled to a Central Processing Unit (CPU) configured to carry out the instructions of a computer program. Computing and other such devices discussed herein are therefore configured to perform basic arithmetical, logical, and input/output operations.

Computing and other devices discussed herein can include memory. Memory can comprise volatile or non-volatile memory as required by the coupled computing device or processor to not only provide space to execute the instructions or algorithms, but to provide the space to store the instructions themselves. In one embodiment, volatile memory can include random access memory (RAM), dynamic random access memory (DRAM), or static random access memory (SRAM), for example. In one embodiment, non-volatile memory can include read-only memory, flash memory, ferroelectric RAM, hard disk, floppy disk, magnetic tape, or optical disc storage, for example. The foregoing lists in no way limit the type of memory that can be used, as these embodiments are given only by way of example and are not intended to limit the scope of the disclosure.

In one embodiment, the system or components thereof can comprise or include various modules or engines, each of which is constructed, programmed, configured, or otherwise adapted to autonomously carry out a function or set of functions. The term "engine" as used herein is defined as a real-world device, component, or arrangement of components implemented using hardware, such as by an application specific integrated circuit (ASIC) or field programmable gate array (FPGA), for example, or as a combination of hardware and software, such as by a microprocessor system and a set of program instructions that adapt the engine to implement the particular functionality, which (while being executed) transform the microprocessor system into a special-purpose device. An engine can also be implemented as a combination of the two, with certain functions facilitated by hardware alone, and other functions facilitated by a combination of hardware and software. In certain implementations, at least a portion, and in some cases, all, of an engine can be executed on the processor(s) of one or more computing platforms that are made up of hardware (*e.g.*, one or more processors, data storage devices such as memory or drive storage, input/output facilities such as network interface devices, video devices, keyboard, mouse or touchscreen devices, etc.) that execute an operating system, system programs, and application programs, while also implementing the engine using multitasking, multithreading, distributed (e.g., cluster, peer-peer, cloud, etc.) processing where appropriate, or other such techniques. Accordingly, each engine can be realized in a variety of physically realizable configurations, and should generally not be limited to any particular implementation exemplified herein, unless such limitations are expressly called out. In addition, an engine can itself be composed of more than one sub-engines, each of which can be regarded as an engine in its own right. Moreover, in the embodiments described herein, each of the various engines corresponds to a defined autonomous functionality; however, it should be understood that in other contemplated embodiments, each functionality can be distributed to more than one engine. Likewise, in other contemplated embodiments, multiple defined functionalities may be implemented by a single engine that performs those multiple functions, possibly alongside other functions, or distributed differently among a set of engines than specifically illustrated in the examples herein.

Various embodiments of systems, devices, and methods have been described herein. These embodiments are given only by way of example and are not intended to limit the scope of the claimed inventions. It should be appreciated, moreover, that the various features of the embodiments that have been described may be combined in various ways to produce numerous additional embodiments. Moreover, while various materials, dimensions, shapes, configurations and locations, etc. have been described for use with disclosed embodiments, others besides those disclosed may be utilized without exceeding the scope of the claimed inventions.

Persons of ordinary skill in the relevant arts will recognise that embodiments may comprise fewer features than illustrated in any individual embodiment described above. The embodiments described herein are not meant to be an exhaustive presentation of the ways in which the various features may be combined. Accordingly, the embodiments are not mutually exclusive combinations of features; rather, embodiments can comprise a combination of different individual features selected from different individual embodiments, as understood by persons of ordinary skill in the art. Moreover, elements described with respect to one embodiment can be implemented in other embodiments even when not described in such embodiments unless otherwise noted. Although a dependent claim may refer in the claims to a specific combination with one or more other claims, other embodiments can also include a combination of the dependent claim with the subject matter of each other dependent claim or a combination of one or more features with other dependent or independent claims. Such combinations are proposed herein unless it is stated that a specific combination is not intended. Furthermore, it is intended also to include features of a claim in any other independent claim even if this claim is not directly made dependent to the independent claim.

Moreover, reference in the specification to "one embodiment," "an embodiment," or "some embodiments" means that a particular feature, structure, or characteristic, described in connection with the embodiment, is included in at least one embodiment of the teaching. The appearances of the phrase "in one embodiment" in various places in the specification are not necessarily all referring to the same embodiment.

Any incorporation by reference of documents above is limited such that no subject matter is incorporated that is contrary to the explicit disclosure herein. Any incorporation by reference of documents above is further limited such that no claims included in the documents are incorporated by reference herein. Any incorporation by reference of documents above is yet further limited such that any definitions provided in the documents are not incorporated by reference herein unless expressly included herein.

Each feature disclosed herein, and (where appropriate) as part of the claims and drawings may be provided independently or in any appropriate combination.

Any reference numerals appearing in the claims are for illustration only and shall not limit the scope of the claims.

## Claims

1. An apparatus for detecting an Electro-Magnetic, EM, field, said apparatus comprising a:

   first Rydberg-Atom EM Field Detector, RAEM-FD, configured to detect a first EM field;
   second RAEM-FD configured to detect a second EM field; and
   waveguide arranged and configured to guide propagation of the first and second EM fields towards the first and second RAEM-FDs.

2. An apparatus according to Claim 1, wherein the first EM field is different from the second EM field as to, at least:

   frequency;
   modulation; and/or
   transmit power.

3. An apparatus according to Claim 1 or 2, wherein the waveguide comprises a:

   Multi-Plate WaveGuide, MPWG;
   Tapered-Plate WaveGuide, TPWG;
   Parallel-Plate WaveGuide, PPWG;
   horn; and/or
   lens.

4. An apparatus according to any preceding claim, wherein the second RAEM-FD is arranged downstream of the first RAEM-FD and the waveguide.

5. An apparatus according to any preceding claim when dependent upon Claim 2, wherein the first and second EM fields are different at least as to frequency, and the waveguide comprises a convergent lens having a first focus associated with a first frequency of the first EM field and a second focus associated with a second frequency of the second EM field, wherein the first RAEM-FD is arranged at said first focus and the second RAEM-FD is arranged at said second focus.

6. An apparatus according to any preceding claim, wherein the waveguide comprises a divergent lens.

7. The apparatus according to any preceding claim, further comprising a controller configured to tune the first RAEM-FD and/or the second RAEM-FD to detect a third EM field, different to the first and/or second EM field/s.

8. The apparatus according to any preceding claim, further comprising a signal processor arranged in communication with the first RAEM-FD and the second RAEM-FD, and configured to receive measurements of the first EM field and second EM field as detected by the respective first RAEM-FD and second RAEM-FD, wherein the signal processor is further configured to process said measurements as single-channel and/or multi-channel communications.

9. A radio receiver for a wireless telecommunications network comprising the apparatus according to any preceding claim.

Figure 1

Figure 2a

Figure 2b

Figure 2c

Figure 3

Europäisches Patentamt

European Patent Office

Office européen des brevets

# EUROPEAN SEARCH REPORT

**Application Number**

EP 24 21 6633

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/393379 A1 (NOAMAN MOHAMMAD [CA] ET AL) 28 November 2024 (2024-11-28) | 1-4,9 | INV.<br>G01R29/08 |
| A | * paragraphs [0044] - [0108]; claims 1-30; figures 1-6D * | 5-8 | |
| X | US 2019/187198 A1 (ANDERSON DAVID A [US] ET AL) 20 June 2019 (2019-06-20) | 1-4,9 | |
| Y | * paragraphs [0051] - [0195]; claims 1-56; | 1-3,9 | |
| A | figures 1-27B * | 5-8 | |
| Y | US 11 300 599 B1 (AMARLOO HADI [CA] ET AL) 12 April 2022 (2022-04-12)<br>* columns 2-17; claims 1-29; figures 1A-6B * | 1-3,9 | |

TECHNICAL FIELDS SEARCHED (IPC)

G01R

The present search report has been drawn up for all claims

| Place of search | Date of completion of the search | Examiner |
|---|---|---|
| Munich | 16 May 2025 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 752 569 A1

## ANNEX TO THE EUROPEAN SEARCH REPORT
## ON EUROPEAN PATENT APPLICATION NO.

EP 24 21 6633

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2025

| Patent document cited in search report | Publication date | Patent family member(s) | | Publication date |
|---|---|---|---|---|
| US 2024393379 A1 | 28-11-2024 | US | 2024393379 A1 | 28-11-2024 |
| | | WO | 2024239101 A1 | 28-11-2024 |
| US 2019187198 A1 | 20-06-2019 | CA | 3085935 A1 | 27-06-2019 |
| | | CN | 112867934 A | 28-05-2021 |
| | | EP | 3729112 A1 | 28-10-2020 |
| | | EP | 4542237 A2 | 23-04-2025 |
| | | JP | 7470643 B2 | 18-04-2024 |
| | | JP | 2021507271 A | 22-02-2021 |
| | | JP | 2024088744 A | 02-07-2024 |
| | | KR | 20200128655 A | 16-11-2020 |
| | | KR | 20230044321 A | 03-04-2023 |
| | | US | 2019187198 A1 | 20-06-2019 |
| | | US | 2021048465 A1 | 18-02-2021 |
| | | US | 2022326289 A1 | 13-10-2022 |
| | | WO | 2019126038 A1 | 27-06-2019 |
| US 11300599 B1 | 12-04-2022 | EP | 4323779 A1 | 21-02-2024 |
| | | EP | 4323780 A1 | 21-02-2024 |
| | | EP | 4323781 A1 | 21-02-2024 |
| | | JP | 7567068 B2 | 15-10-2024 |
| | | JP | 7603174 B2 | 19-12-2024 |
| | | JP | 2024517080 A | 19-04-2024 |
| | | JP | 2024517081 A | 19-04-2024 |
| | | JP | 2024517082 A | 19-04-2024 |
| | | US | 11300599 B1 | 12-04-2022 |
| | | US | 11307233 B1 | 19-04-2022 |
| | | US | 11313926 B1 | 26-04-2022 |
| | | US | 11391797 B1 | 19-07-2022 |
| | | WO | 2022217335 A1 | 20-10-2022 |
| | | WO | 2022217336 A1 | 20-10-2022 |
| | | WO | 2022217337 A1 | 20-10-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 24197354

- EP 24179958

### Non-patent literature cited in the description

- **C. HOLLOWAY et al.** A Multiple-Band Rydberg Atom-Based Receiver: AM/FM Stereo Reception. *IEEE Antennas and Propagation Magazine*, June 2021, vol. 63 (3), 63-76

- **D. A. ANDERSON et al.** An Atomic Receiver for AM and FM Radio Communication. *IEEE Transactions on Antennas and Propagation*, May 2021, vol. 69 (5), 2455-2462
- *British Telecommunications public limited company*, 15-16